# FASCICULE DE BREVET EUROPEEN

(11) **EP 1 936 669 B1**
(45) Date de publication et mention de la délivrance du brevet: **19.08.2009**
(21) Numéro de dépôt: 07123409.0
(22) Date de dépôt: 17.12.2007
(51) Int. Cl.: H01L 21/20, H01L 21/762, H01L 21/8258

(54) **Procédé de fabrication d'un substrat SOI associant des zones à base de silicium et des zones à base de GaAs**
Herstellungsverfahren eines SOI-Substrats durch Assoziation von Zonen auf Siliziumbasis und Zonen auf GaAs-Basis
Method of manufacturing an SOI substrate combining silicon-based areas and GaAs-based areas

(30) Priorité: 21.12.2006 FR 0655825
(43) Date de publication de la demande: 25.06.2008
(73) Titulaire: COMMISSARIAT A L'ENERGIE ATOMIQUE, 75015 Paris (FR)
(72) Inventeur: Clavelier, Laurent, 38000, GRENOBLE (FR); Deguet, Chrystal, 38330, SAINT ISMIER (FR)
(74) Mandataire: Poulin, Gérard

(56) Documents cités:
- WO-A-20/04010496
- FR-A- 2 842 217
- US-A- 4 551 394
- US-A1- 2006 170 045
- TAKAI M. ET AL.: "Gallium Arsenide layers grown by molecular beam epitaxy on single crystalline germanium islands on insulator" JAPANESE JOURNAL OF APPLIED PHYSICS, vol. 23, no. 5, mai 1984 (1984-05), pages L308-L310, XP002440750

## Description

### DOMAINE TECHNIQUE

L'invention se rapporte à un procédé de fabrication d'un substrat SOI associant des zones à base de silicium et des zones à base de GaAs. Par l'expression « à base de GaAs », on entend aussi bien le matériau GaAs que les composés ternaires et quaternaires associées au GaAs comme par exemple InGaAs, InGaAsP, InGaAsAl, etc...

### ÉTAT DE LA TECHNIQUE ANTÉRIEURE

Actuellement, la microélectronique sur silicium (CMOS) et la technologie des matériaux semiconducteurs III-V à base de GaAs (matériau très utilisé pour les applications optroniques) suivent des voies de réalisation technologiques distinctes. En effet, les dispositifs combinant des composants CMOS et des composants en GaAs sont obtenus généralement par des techniques d'hybridation telles que le report de composants en GaAs achevés sur des circuits CMOS achevés et leurs connexions électriques (par exemple par des fils conducteurs ou par des techniques de bosses ou « bumps » en anglais). L'une des raisons à cela est que les substrats utilisés pour réaliser des circuits CMOS ne sont pas les mêmes que ceux utilisés pour faire croître des matériaux GaAs. Les circuits CMOS sont réalisés sur des substrats de silicium massif ou sur des substrats SOI (silicium-sur-isolant) tandis que les matériaux GaAs sont obtenus par croissance sur des substrats en germanium ou sur des substrats en GeOI (germanium-sur-isolant) désorientés idéalement de 6° par rapport aux plans (001) ou encore sur des substrats massifs de GaAs. Ces voies de réalisation technologiques rendent, à l'heure actuelle, impossible la fabrication de circuits CMOS et la croissance de GaAs sur un même substrat.

La technique de report/connexion de composants GaAs sur un circuit CMOS présente plusieurs inconvénients. Cette technique est coûteuse, surtout si plusieurs composants à base de GaAs doivent être reportés sur un circuit CMOS. Il existe aussi une barrière technologique à la miniaturisation des objets. En effet, le report d'un composant GaAs sur un circuit CMOS se fait aujourd'hui avec une précision d'au mieux 1 µm, ce qui nécessite de prévoir des règles de dessin très relâchées, d'où beaucoup de pertes de place et un handicap à la miniaturisation. En outre, cette technique est difficile à mettre en oeuvre car elle demande plus d'efforts à faire (en termes de design, de technologie,...) pour réduire les pertes de couplage d'un composant par rapport à un autre et cela bien souvent au détriment de la performance des composants.

Une intégration monolithique sur un même substrat, c'est-à-dire un substrat comportant à la fois des zones Si ou SOI, pour réaliser des circuits CMOS, et des zones Ge ou GeOI désorienté (idéalement de 6° par rapport aux plans (001)), pour réaliser la croissance de GaAs, peut permettre de résoudre certains des inconvénients mentionnés ci-dessus.

Le document WO 2004/010496 A1 divulgue un procédé de réalisation d'un substrat présentant une zone en GaAs coexistant avec une zone en silicium. La fabrication d'un tel substrat débute par le collage d'une couche de germanium sur un substrat de silicium recouvert d'une couche d'oxyde de silicium. Par élimination partielle de la couche de germanium suivie d'étapes de croissance, ou obtient une zone de silicium adjacente à une zone de GaAs épitaxiée sur du germanium. Ce procédé présente plusieurs inconvénients. Le substrat de départ est un substrat GeOI, donc un substrat rare et cher. Le germanium servant à la croissance de GaAs est non désorienté, ce qui peut provoquer des problèmes de domaines d'antiphase lors de la croissance de GaAs. Les dispositifs en silicium sont réalisés sur du silicium massif. On ne peut donc pas bénéficier des avantages électrostatiques du SOI (réduction des effets de canaux courts, réduction des capacités de jonction, gains en radiofréquence,...). De manière générale, ce procédé ne permet pas une co-intégration SOI-GeOI-GaAsOI.

Le brevet US 6 171 936 B1 divulgue un procédé de fabrication d'une structure présentant des zones en GaAs coexistant avec des zones en silicium à partir duquel on forme des zones en SiGe via des couches tampon en SiGe graduel. Les composants CMOS sont réalisés sur le silicium massif et des couches de GaAs sont épitaxiées sur du germanium terminant les zones en SiGe et à partir de surfaces de germanium non-désorientées. Ce procédé présente plusieurs inconvénients. Les dispositifs en silicium sont réalisés sur du silicium massif, ce qui présente les mêmes inconvénients que pour le procédé du document WO 2004/010 496 A1. La réalisation de la couche de GaAs se fait via la croissance de couches tampon de SiGe graduel qui présentent une épaisseur importante (plusieurs µm), ce qui revient cher et engendre une contrainte mécanique pouvant être gênante. En effet, une plaque déformée est difficile à traiter. Enfin, le GaAs n'est pas « sur isolant », ce qui entraîne les mêmes remarques que pour les dispositifs en silicium.

Le brevet US 2006170045 A1 divulgue un procédé de fabrication d'un substrat SOI présentant des régions d'orientation cristalline différentes. Cette structure est obtenue par élimination d'une zone non préservée de la couche mince reposant sur la couche diélectrique jusqu'à atteindre cette couche diélectrique. La face du support est ensuite révélée par ouverture, dans la zone non préservée, de la couche de diélectrique. Un matériau semiconducteur présentant une première orientation cristalline est épitaxiée à partir de la portion de support révélée par l'ouverture, et une croissance épitaxiale d'un second matériau semiconducteur présentant une deuxième orientation cristalline est réalisée à partir des régions restantes de la couche mince située sur la couche diélectrique.

### EXPOSÉ DE L'INVENTION

L'invention permet de remédier aux inconvénients de l'art antérieur.

Il est proposé un procédé de fabrication d'un substrat SOI associant au moins une zone à base de silicium et au moins une zone en matériau à base de GaAs au niveau de la couche mince du substrat SOI, le substrat SOI comprenant un support présentant une face en silicium supportant successivement une couche de matériau diélectrique et une couche mince à base de silicium, le procédé étant caractérisé en ce qu'il comprend les étapes suivantes :
- fourniture d'un substrat SOI comprenant un support présentant une face en silicium désorienté d'un angle compris entre 2° et 10°, la couche mince à base de silicium étant d'orientation parallèle au plan (001) ou (010) ou (100) ou (110) ou (101) ou (011) ou (111),
- préservation d'au moins une zone de la couche mince de silicium,
- élimination d'au moins une zone non préservée de la couche mince de silicium jusqu'à révéler la couche de matériau diélectrique,
- ouverture, dans ladite zone non préservée, de la couche de matériau diélectrique jusqu'à révéler la face en silicium du support,
- croissance, à partir du silicium de support révélé par ladite ouverture et par épitaxie en phase liquide ou par épitaxie latérale, de germanium désorienté sur la couche de matériau diélectrique révélée,
- croissance de matériau à base de GaAs à partir du germanium désorienté obtenu à l'étape précédente.

De préférence, le support présente une face en silicium désorienté d'un angle compris entre 4° et 8°. De préférence encore, le support présente une face en silicium désorienté d'un angle de 6°.

L'étape de préservation d'au moins une zone de la couche mince de silicium peut consister à déposer une couche de protection sur ladite zone de la couche mince de silicium.

Le procédé peut comporter en outre la préservation d'au moins une zone de germanium obtenu par croissance dans la couche mince du substrat SOI afin d'y empêcher la croissance de matériau à base de GaAs.

Au moins un composant, notamment un composant électronique, peut être réalisé dans ladite zone de silicium avant l'étape de croissance de germanium.

Selon un mode de réalisation, après la croissance du matériau à base de GaAs, on réalise d'abord au moins un composant, notamment un composant électronique, dans la zone de silicium, puis au moins un composant, notamment un composant opto-électronique, dans la zone en matériau à base de GaAs.

Selon une application particulière, au moins un composant électronique est réalisé dans ladite zone en silicium, au moins un récepteur transformant un signal optique en signal électrique est réalisé dans ladite zone en germanium préservée, au moins un émetteur transformant un signal électrique en signal optique est réalisé dans ladite zone en matériau à base de GaAs, au moins un premier guide optique et un deuxième guide optique sont réalisés à partir d'une zone préservée de la couche mince de silicium, de sorte que le premier guide optique permet de véhiculer un signal optique jusqu'au récepteur qui transmet un signal électrique correspondant à une entrée du composant électronique, et de sorte que le deuxième guide optique permet de véhiculer un signal optique correspondant à un signal électrique émis par une sortie du composant électrique et transitant par l'émetteur.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1I sont des vues en coupe transversale illustrant le procédé de fabrication selon la présente invention,
- la figure 2 est une vue de dessus montrant un exemple de circuits CMOS reliés par des interconnexions optiques.

### EXPOSÉ DÉTAILLÉ DE MODES DE RÉALISATION PARTICULIERS

L'invention permet de réaliser sur un même substrat à la fois des zones SOI appropriées à la réalisation de CMOS (on choisira l'orientation de la couche de silicium de cette zone en fonction de l'application, par exemple du silicium (001) pour les applications CMOS) et des zones de GeOI (dont la couche de Ge est désorientée par rapport au plan (001)) appropriées à la croissance de GaAs. Le GaAs est avantageusement utilisé pour ses propriétés optiques (laser) ou électriques (transistors HBT, HEMT ou n-MOS) car la mobilité des électrons dans le GaAs est très élevée.

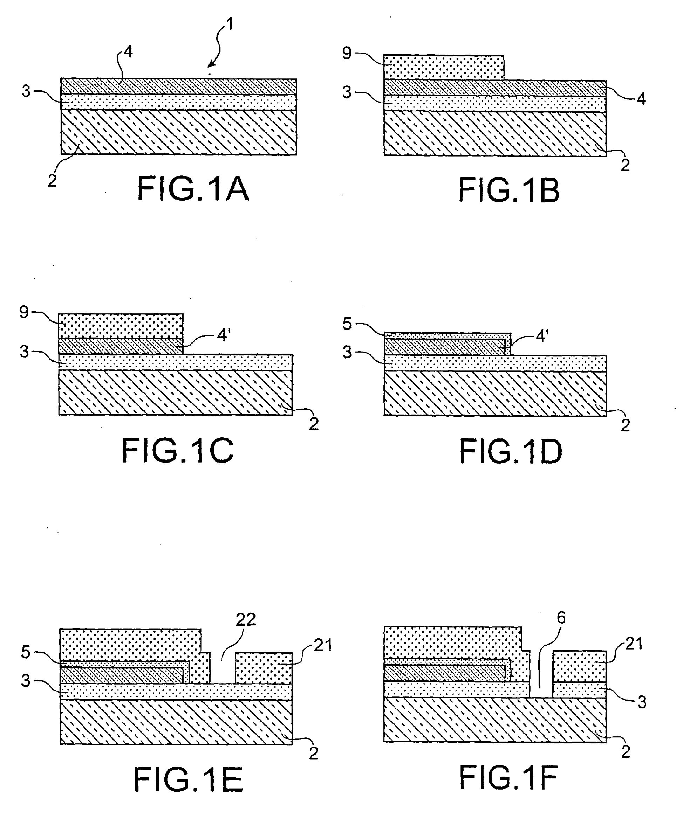

Les figures 1A à 1I sont des vues en coupe transversale illustrant le procédé de fabrication selon la présente invention.

La figure 1A montre un substrat SOI 1 approprié pour la mise en oeuvre de la présente invention. Le substrat 1 comprend un support 2 en silicium (001) dont la normale au plan est désorientée d'un angle compris entre 2° et 10°, typiquement entre 4° et 8° et idéalement 6° vers la direction <111>. Le support 2 supporte une couche de matériau diélectrique 3 et une couche mince de silicium 4. La couche de matériau diélectrique 3 peut être du SiO₂, du Si₃N₄ ou de l'Al₂O₃. De préférence, cette couche est en oxyde thermique. La couche mince 4 est en silicium dit classique, c'est-à-dire d'orientation parallèle au plan (001) ou (010) ou (100) ou (110) ou (101) ou (011) ou (111).

La suite du procédé va permettre d'obtenir, dans cet exemple de réalisation, un substrat présentant, au niveau de la couche active, une zone de silicium et une zone de GaAs. Pour cela, on conserve et on protège le silicium de la couche mince à l'endroit désiré pour la zone de silicium et on élimine le silicium de la couche mince à l'endroit désiré pour la zone de GaAs.

La figure 1B montre une couche de résine 9 lithographiée sur la couche mince 4. La couche de résine 9 formant un masque de protection, la partie non masquée de la couche mince 4 est gravée jusqu'à révéler la couche de matériau diélectrique 3. Il subsiste, sous le masque de résine 9, une zone 4' de silicium (voir la figure 1C).

Le masque de résine est éliminé et une couche de protection 5 constituant un masque dur est formée sur la zone 4' de silicium (voir la figure 1D). La couche de protection 5 peut être en SiO₂ ou en Si₃N₄. La contrainte technologique pour cette couche de protection est sa tenue au budget technique induit pat la croissance de GaAs. La couche de protection doit servir de couche d'arrêt au polissage mécano-chimique du GaAS si le polissage est nécessaire pour niveler les zones de GaAs et de Si. Elle doit être en un matériau permettant la croissance de GaAs si nécessaire.

On dépose ensuite une couche de résine 21 sur la structure obtenue (voir la figure 1E). La couche de résine 21 est lithographiée et présente une ouverture 22 révélant la couche de matériau diélectrique 3. La couche 3 est alors gravée à partir de l'ouverture 22 jusqu'à révéler le substrat de silicium 2 au fond de l'ouverture 6 (voir la figure 1F).

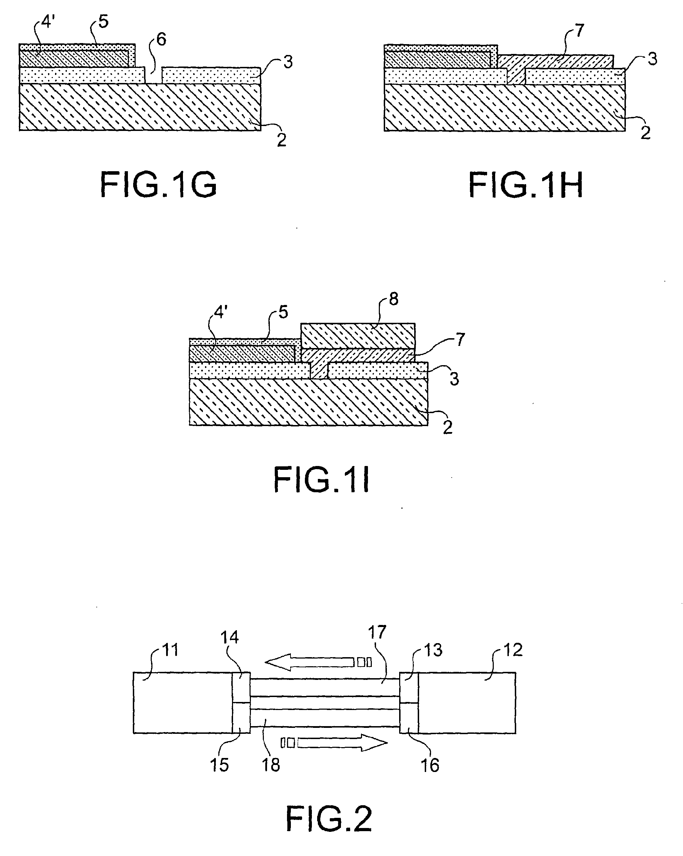

La couche de résine 21 est alors éliminée. On obtient la structure montrée à la figure 1G. La surface de silicium révélée par l'ouverture 6 servira de « germe » pour la croissance du germanium.

A partir du silicium révélé par l'ouverture 6, on fait croître une couche de germanium désorienté selon le même angle que pour le silicium du support. Ainsi, si le support 2 est en silicium désorienté d'un angle de 6°, la couche 7 de germanium obtenue (voir la figure 1H) est également désorientée de 6°. La croissance du germanium peut être obtenue par la technique d'épitaxie dite LPE (pour « Liquid Phase Epitaxy ») ou bien par épitaxie latérale de germanium. Eventuellement, une planarisation mécano-chimique du germanium peut être réalisée.

Ensuite, comme le montre la figure 1I, on fait croître une couche de GaAs sur la couche de germanium 7. Le germanium et le GaAs ayant des paramètres de maille concordants, l'angle de désorientation de 6° de la couche de germanium permet d'éviter les problèmes liés aux domaines d'antiphase lors de la croissance. La couche de protection 5 peut alors être éliminée pour mettre à nu la zone de silicium 4' qui se trouve à proximité de la zone de GaAs 8.

La zone de silicium permettra la réalisation de composants selon la technologie CMOS. Chronologiquement, en fonctions des budgets thermiques que peuvent subir chaque type de composant, on peut par exemple réaliser :
- d'abord des MOSFET sur le substrat SOI (dans la future zone de silicium) de la figure 1A, puis la croissance de germanium et du GaAs et enfin les composants sur la zone de GaAs ; ou
- d'abord la croissance du germanium et du GaAs, ensuite les MOSFET sur la zone du silicium et enfin les composants sur la zone de GaAs.

L'invention n'est pas limitée à la croissance du matériau GaAs. Elle s'applique également aux composés ternaires et quaternaires associés aux GaAs, comme par exempel InGaAs, InGaAsP, InGaAsAl, etc...

Grâce à l'invention, il est possible d'obtenir sur un même substrat des zones SOI, des zones GeOI (en protégeant une zone de germanium avant la croissance de GaAs sur une autre zone de germanium) et des zones GaAs sur GeOI. Cette approche est intéressante pour réaliser des circuits avec interconnexions optiques intra-puces du type :
- CMOS et guides optiques sur SOI,
- émetteurs de lumière (par transformation d'un signal électrique en un signal lumineux) sur GaAs,
- détecteurs de lumière (par transformation d'un signal lumineux en un signal électrique) sur GeOI.

La figure 2 est une vue de dessus illustrant cette possibilité. Cette vue montre deux circuits CMOS 11 et 12 réalisés sur SOI, deux émetteurs de lumière réalisés sur GeOI 13 et 15, deux détecteurs de lumière réalisés sur GaAs 14 et 16 et deux guides optiques 17 et 18 réalisés en utilisant Si comme coeur de guide et SiO₂ comme couches de confinement.

Ainsi des flux d'information peuvent circuler dans les deux sens entre les circuits CMOS 11 et 12. Un signal électrique émis par le circuit CMOS 12 est transformé en signal lumineux par l'émetteur de lumière 13. Ce signal lumineux est véhiculé par le guide optique 17 jusqu'au détecteur 14 qui fournit un signal électrique au circuit CMOS 11. Un signal électrique émis par le circuit CMOS 11 est transformé en signal lumineux par l'émetteur de lumière 15. Ce signal lumineux est véhiculé par le guide optique 18 jusqu'au détecteur 16 qui fournit un signal électrique au circuit CMOS 12.

Cette approche peut être mise en oeuvre en jouant à la fois sur les épaisseurs d'oxyde (par contrôle de gravure et/ou de dépôt) et sur l'épaisseur de couches épitaxiées. Par exemple, dans le cas de la figure 4, il est possible de graver l'oxyde enterré et de contrôler l'épaisseur de Ge, pour pouvoir réaliser un émetteur ou un détecteur dans la couche de GaAs qui soit aligné avec des composants actifs ou passifs situés dans la couche de Si, afin de minimiser les pertes de couplage.

## Revendications

1. Procédé de fabrication d'un substrat SOI associant au moins une zone à base de silicium (4') et au moins une zone en matériau à base de GaAs (8) au niveau de la couche mince du substrat SOI (1), le substrat SOI comprenant un support (2) présentant une face en silicium supportant successivement une couche de matériau diélectrique (3) et une couche mince à base de silicium (4), le procédé étant **caractérisé en ce qu'**il comprend les étapes suivantes :
- fourniture d'un substrat SOI (1) comprenant un support (2) présentant une face en silicium désorienté d'un angle compris entre 2° et 10°, la couche mince à base de silicium (4) étant d'orientation parallèle au plan (001) ou (010) ou (100) ou (110) ou (101) ou (011) ou (111),
- préservation d'au moins une zone (4') de la couche mince à base de silicium (4),
- élimination d'au moins une zone non préservée de la couche mince de silicium jusqu'à révéler la couche de matériau diélectrique (3),
- ouverture, dans ladite zone non préservée, de la couche de matériau diélectrique (3) jusqu'à révéler la face en silicium du support (2),
- croissance, à partir du silicium de support (2) révélé par ladite ouverture (6) et par épitaxie en phase liquide ou par épitaxie latérale, de germanium désorienté (7) sur la couche de matériau diélectrique révélée,
- croissance de matériau à base de GaAs (8) à partir du germanium désorienté (7) obtenu à l'étape précédente.

2. Procédé selon la revendication 1, dans lequel le support (2) présente une face en silicium désorienté d'un angle compris entre 4° et 8°.

3. Procédé selon la revendication 2, dans lequel le support (2) présente une face en silicium désorienté d'un angle de 6°.

4. Procédé selon l'une quelconque des revendications 1 à 3, dans lequel la couche de matériau diélectrique (3) est en matériau choisi parmi SiO₂, Si₃N₄ et Al₂O₃.

5. Procédé selon l'une quelconque des revendications 1 à 4, dans lequel l'étape de préservation d'au moins une zone de la couche mince de silicium (4') consiste à déposer une couche de protection (5) sur ladite zone de la couche mince de silicium.

6. Procédé selon l'une quelconque des revendications 1 à 5, comportant en outre la préservation d'au moins une zone de germanium obtenu par croissance dans la couche mince du substrat SOI afin d'y empêcher la croissance de matériau à base de GaAs.

7. Procédé selon l'une quelconque des revendications 1 à 6, dans lequel au moins un composant est réalisé dans ladite zone de silicium avant l'étape de croissance de germanium.

8. Procédé selon l'une quelconque des revendications 1 à 6, dns lequel, après la croissance du matériau à base de GaAs, on réalise d'abord au moins un composant dans la zone de silicium, puis au moins un composant dans la zone en matériau à base de GaAs.

9. Procédé selon la revendication 6, dans lequel au moins un composant électronique (11, 12) est réalisé dans ladite zone en silicium, au moins un récepteur (14, 16) transformant un signal optique en signal électrique est réalisé dans ladite zone en germanium préservée, au moins un émetteur (13, 15) transformant un signal électrique en signal optique est réalisé dans ladite zone en matériau à base de GaAs, au moins un premier guide optique (17) et un deuxième guide optique (18) sont réalisés à partir d'une zone préservée de la couche mince de silicium, de sorte que le premier guide optique (17) permet de véhiculer un signal optique jusqu'au récepteur (14, 16) qui transmet un signal électrique correspondant à une entrée du composant électronique (11, 12), et de sorte que le deuxième guide optique (18) permet de véhiculer un signal optique correspondant à un signal électrique émis par une sortie du composant électrique (11, 12) et transitant par l'émetteur (13, 15).

## Claims

1. Method for manufacturing an SOI substrate associating at least one silicon based area (4') and at least one GaAs based material area (8) at the thin layer (1) of the SOI substrate, the SOI substrate comprising a support (2) having a silicon face supporting successively a layer (3) of dielectric material and a thin silicon based layer (4), the method being **characterised in that** it comprises the following steps:
- supply of a SOI substrate (1) comprising a support (2) having a silicon face mismatched by an angle of between 2° and 10° inclusive, the thin silicon based layer (4) being oriented parallel to the plane (001) or (010) or (100) or (110) or (101) or (011) or (111),
- preservation of at least one area (4') of the thin silicon based layer (4),
- elimination of at least one non-preserved area of the thin layer of silicon until the layer (3) of dielectric material is revealed,
- opening, in said non-preserved area, of the dielectric material layer (3) until the silicon face of the support (2) is revealed,
- growth, from the silicon of the support (2) revealed by said opening (6) and by liquid phase epitaxy or by lateral epitaxy, of mismatched germanium (7) on the dielectric material layer revealed,
- growth of the GaAs based material (8), from mismatched germanium (7) obtained in the preceding step.

2. Method according to claim 1, in which the support (2) has a silicon face mismatched by an angle of between 4° and 8° inclusive.

3. Method according to claim 2, in which the support (2) has a silicon face mismatched by an angle of 6°.

4. Method according to any one of claims 1 to 3, in which the dielectric material layer (3) is a material chosen from among SiO₂, Si₃N₄ and Al₂O₃.

5. Method according to any one of claims 1 to 4, in which the step of preserving at least one thin silicon layer area (4') consists of depositing a protective layer (5) on said area of the thin silicon layer.

6. Method according to any one of claims 1 to 5, also incorporating the preservation of at least one germanium area obtained by growth in the thin layer of the SOI substrate in order to prevent the growth there of GaAs based material.

7. Method according to any one of claims 1 to 6, in which at least one component is produced in said silicon area before the germanium growing step.

8. Method according to any one of claims 1 to 6, in which, after growing the GaAs based material, at least one component is produced initially in the silicon area, then at least one component in the area of GaAs based material.

9. Method according to claim 6, in which at least one electronic component (11, 12) is produced in said silicon area, at least one receiver (14, 16) transforming an optical signal into an electrical signal is produced in said preserved germanium area, at least one emitter (13, 15) transforming an electrical signal into an optical signal is produced in said area of GaAs based material, at least one first optical guide (17) and a second optical guide (18) are produced from a preserved area of the thin layer of silicon, such that the first optical guide (17) can convey an optical signal to the receiver (14, 16) which transmits a corresponding electrical signal to an input of the electronic component (11, 12), and such that the second optical guide (18) can convey an optical signal corresponding to an electrical signal emitted by an output of the electrical component (11, 12) and transiting through the emitter (13, 15).

## Patentansprüche

1. Herstellungsverfahren eines SOI-Substrats durch Assoziation von wenigstens einer Zone auf Siliciumbasis (4') und wenigstens einer Zone auf GaAs-Basis (8) auf Höhe der dünnen Schicht des SOI-Substrats (1), wobei das SOI-Substrat einen Träger (2) mit einer Seite aus Silicium aufweist, die sukzessiv eine Schicht aus dielektrischem Material (3) und eine dünne Schicht (4) auf Siliciumbasis trägt, und das Verfahren dabei **dadurch gekennzeichnet ist, dass** es umfasst:
- Lieferung eines SOI-Substrats (1) mit einem Träger (2), der eine Seite aus Silicium, desorientiert um einen zwischen 2° und 10° enthaltenen Winkel, umfasst, wobei die dünne Schicht (4) auf Siliciumbasis parallel orientiert ist zu der Ebene (001) oder (010) oder (100) oder (110) oder (101) oder (011) oder (111),
- Schutz wenigstens einer Zone (4') der dünnen Schicht auf Siliciumbasis (4),
- Elimination wenigstens einer ungeschützten Zone der dünnen Siliciumschicht bis zur Freilegung der Schicht (3) aus dielektrischem Material,
- Öffnung, in der genannten ungeschützten Zone, der Schicht (3) aus dielektrischem Material bis zur Freilegung der Siliciumseite des Trägers (2),
- Wachstum - auf dem durch die genannte Öffnung (6) freigelegten Trägersilicium (2) - von desorientiertem Germanium (7) auf der freigelegten Schicht aus dielektrischem Material durch Flüssigphasen-Epitaxie oder durch laterale Epitaxie,
- Wachstum von Material auf der Basis von GaAs (8) auf dem in dem vorangehenden Schritt erzeugten desorientierten Germanium (7).

2. Verfahren nach Anspruch 1, bei dem der Träger (2) eine Seite aus Silicium, desorientiert um einen zwischen 4° und 8° enthaltenen Winkel, umfasst.

3. Verfahren nach Anspruch 2, bei dem der Träger (2) eine Seite aus Silicium, desorientiert um einen Winkel von 6°, umfasst.

4. Verfahren nach einem der Ansprüche 1 bis 3, bei dem die Schicht aus dielektrischem Material (3) aus einem unter SiO₂, Si₃N₄ und Al₂O₃ ausgewählten Material ist.

5. Verfahren nach einem der Ansprüche 1 bis 4, bei dem der Schritt zum Schützen von wenigstens einer Zone der dünnen Siliciumschicht (4') darin besteht, auf der genannten Zone der dünnen Schicht eine Schutzschicht (5) aus Silicium abzuscheiden.

6. Verfahren nach einem der Ansprüche 1 bis 5, außerdem den Schutz von wenigstens einer Zone aus Germanium umfassend, erzeugt durch Wachstum in der dünnen Schicht des SOI-Substrats, um dort das Wachstum von Material auf der Basis von GaAs zu verhindern.

7. Verfahren nach einem der Ansprüche 1 bis 6, bei dem in der genannten Siliciumzone wenigstens eine Komponente realisiert wird, vor dem Germaniumwachstumsschritt.

8. Verfahren nach einem der Ansprüche 1 bis 6, bei dem man, nach dem Wachstum des Materials auf GaAs-Basis, zunächst wenigstens eine Komponente in der Siliciumzone und dann wenigstens eine Komponente in der Zone aus Material auf GaAs-Basis realisiert.

9. Verfahren nach Anspruch 6, bei dem wenigstens eine elektronische Komponente (11, 12) in der genannten Siliciumzone realisiert wird, wenigstens ein Empfänger (14, 16) in der genannten geschützten Germaniumzone realisiert wird, der ein optisches Signal in ein elektrisches Signal umsetzt, wenigstens ein Sender (13, 15) in der Zone aus Material aus GaAs-Basis realisiert wird, der ein elektrisches Signal in ein optisches Signal umsetzt, wenigstens ein erster optischer Leiter (17) und ein zweiter optischer Leiter (18) aus einer geschützten Zone der dünnen Siliciumschicht realisiert werden, so dass der erste optische Leiter (17) ermöglicht, ein optisches Signal zu dem Empfänger (14, 16) zu leiten, der ein entsprechendes elektrisches Signal zu einem Eingang der elektronischen Komponente (11, 12) überträgt, und dass der zweite optische Leiter (18) ermöglicht, ein einem elektrischen Signal entsprechendes, durch einen Ausgang der elektrischen Komponente (11, 12) gesendetes und den Sender (13, 15) durchquerendes optisches Signal zu leiten.
